# EUROPEAN PATENT SPECIFICATION

(11) **EP 3 806 607 B1**
(45) Date of publication and mention of the grant of the patent: **23.07.2025**
(21) Application number: 18921059.4
(22) Date of filing: 31.05.2018
(51) Int. Cl.: H05K 13/02, H05K 13/00, H05K 13/04, H05K 13/08

(54) **COMPONENT MOUNTING SYSTEM AND METHOD FOR INSTRUCTING DISPOSITION OF COMPONENT SUPPLY UNIT**
BAUTEILEMONTAGESYSTEM UND VERFAHREN ZUR ANLEITUNG DER ANORDNUNG EINER KOMPONENTENZUFÜHREINHEIT
SYSTÈME DE MONTAGE DE COMPOSANTS ET PROCÉDÉ POUR DONNER UNE INSTRUCTION DE DISPOSITION D'UNE UNITÉ DE FOURNITURE DE COMPOSANTS

(43) Date of publication of application: 14.04.2021
(73) Proprietor: Fuji Corporation, Chiryu-shi, Aichi 472-8686 (JP)
(72) Inventor: AKATSUKA, Shohei, Chiryu-shi, Aichi 472-8686 (JP); KURODA, Hideya, Chiryu-shi, Aichi 472-8686 (JP)
(74) Representative: Grünecker Patent- und Rechtsanwälte PartG mbB
(86) International application number: PCT/JP2018/020932
(87) International publication number: WO 2019/229924

(56) References cited:
- EP-A1- 3 267 782
- EP-A1- 3 379 910
- EP-A1- 3 541 162
- WO-A1-2016/035145
- WO-A1-2017/085782
- WO-A1-2017/085782
- WO-A1-2018/087854
- JP-A- 2004 186 390
- JP-A- 2008 066 405
- JP-A- 2013 051 240
- JP-A- 2013 207 215
- JP-A- 2013 207 215

## Description

### Technical Field

The present disclosure relates to a mounting system for mounting components on a board, with components picked up from a component supply unit. In particular, this specification discloses a component mounting system and a method for instructing disposition of a component supply unit.

### Background Art

The conventional art has proposed a component mounting system including a component mounter on which a cassette-type feeder (component supply unit) for supplying a component is detachably mounted, and which performs a mounting process of mounting the component on a board by causing a collection member to collect the component from the component supply unit, based on a production job; and a unit exchange device such as a robot for automatically exchanging the feeder (for example, refer to Patent Literature 1). In this system, during the mounting process of the board, the component supply units are subsequently replaced at a position where an operation distance of the collection member is shortened as much as possible when the component is collected and mounted on the board, thereby improving efficiency of the mounting process.

Patent Application WO 2018/087854 A1 relates to a system for mounting components on a board by component mounters, and in particular to production job optimization of component mounting.

Patent Application WO 2017/085782 A1 relates to a component mounting system for mounting components picked up from feeder component on a board by component mounters.

Patent Application EP 3 267 782 A1 relates to a mounting system for mounting components on a circuit board, and in particular to determining arrangement positions of tape feeders on a pallet, so that the production time required for processing the reference job is reduced based on a reference job.

Patent Application JP 2013 207215 A relates to a component mounting system for mounting components on a board by component mounters, ad in particular to determining feeder arrangement positions.

### Patent Literature

Patent Literature 1: WO2017/85782

### Summary of the Invention

### Technical Problem

Incidentally, without being limited to the configuration in which the component supply units are subsequently replaced at the above-described position during the mounting process of the board, another configuration is known in which the mounting process is performed while multiple component supply units are in a mounted state in a predetermined alignment disposition suitable for the mounting process. In this case, each time production jobs are changed, the multiple component supply units required for mounting process need to be mounted to have a predetermined disposition suitable for mounting process based on a new production job. Therefore, when a large number of component supply units are used for the mounting process, it takes time to realign the component supply units, thereby causing a possibility that starting the mounting process may be delayed.

A main object of the present disclosure is to suppress a decrease in efficiency of a mounting process while quickly starting the mounting process when production jobs are changed.

### Solution to Problem

The present disclosure adopts the following means to achieve the main object described above.

The present invention is defined by the features of the independent claims, with preferred embodiments being specified in the dependent claims. References to embodiments which do not fall under the scope of the claims are to be understood as examples useful for understanding the invention.

In this manner, when the production jobs are changed, compared to a case where the mounting process starts after all of the required component supply units are mounted in the predetermined disposition, it is possible to quickly start the mounting process by shortening a time required for mounting the component supply unit. In addition, since the component supply units are re-mounted in the predetermined disposition after the mounting process starts so that the component supply units are in an alignment suitable for the mounting process, it is possible to suppress a significant decrease in efficiency of the mounting process. Therefore, it is possible to suppress a decrease in the efficiency of the mounting process while quickly starting the mounting process when the production jobs are changed.

### Brief Description of Drawings

[Fig. 1] Fig. 1 is a configuration diagram illustrating a schematic configuration of component mounting system 10.
[Fig. 2] Fig. 2 is a configuration diagram illustrating a schematic configuration of component mounter 20.
[Fig. 3] Fig. 3 is a configuration diagram illustrating a schematic configuration of feeder 30.
[Fig. 4] Fig. 4 is a configuration diagram illustrating a schematic configuration of loader 50.
[Fig. 5] Fig. 5 is a configuration diagram relating to controlling of component mounting system 10.
[Fig. 6] Fig. 6 is a view for describing an example of feeder management information.
[Fig. 7] Fig. 7 is a flowchart illustrating an example of a feeder disposition instruction process.
[Fig. 8] Fig. 8 is a flowchart illustrating an example of a disposition instruction process before a mounting process starts.
[Fig. 9] Fig. 9 is a view for describing an example of an optimum disposition of feeder 30.
[Fig. 10] Fig. 10 is a view for describing a disposition status of feeder 30 when the mounting process is completed based on a previous production job.
[Fig. 11] Fig. 11 is a view for describing a disposition status of feeder 30 by a disposition instruction before the mounting process start.
[Fig. 12] Fig. 12 is a flowchart illustrating an example of the disposition instruction process after the mounting process starts.
[Fig. 13] Fig. 13 is a view for describing a state of delay time ΔT and disposition change in feeder 30.

### Description of Embodiments

Next, an embodiment of the present disclosure will be described with reference to the drawings.

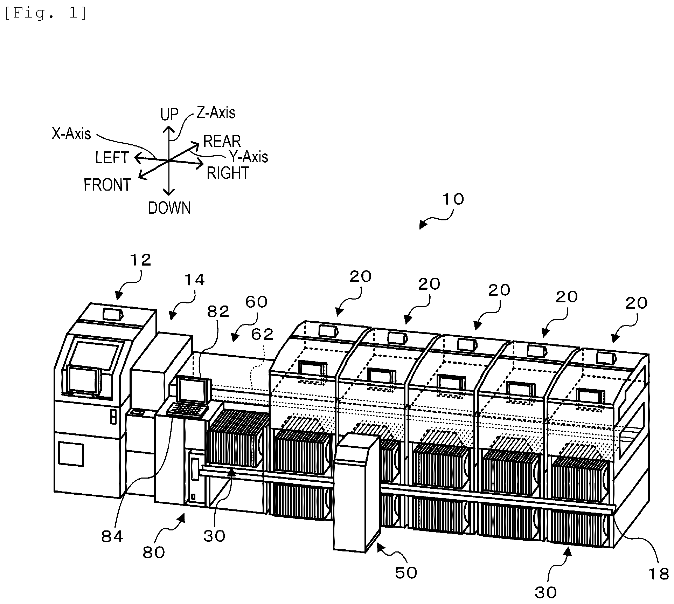

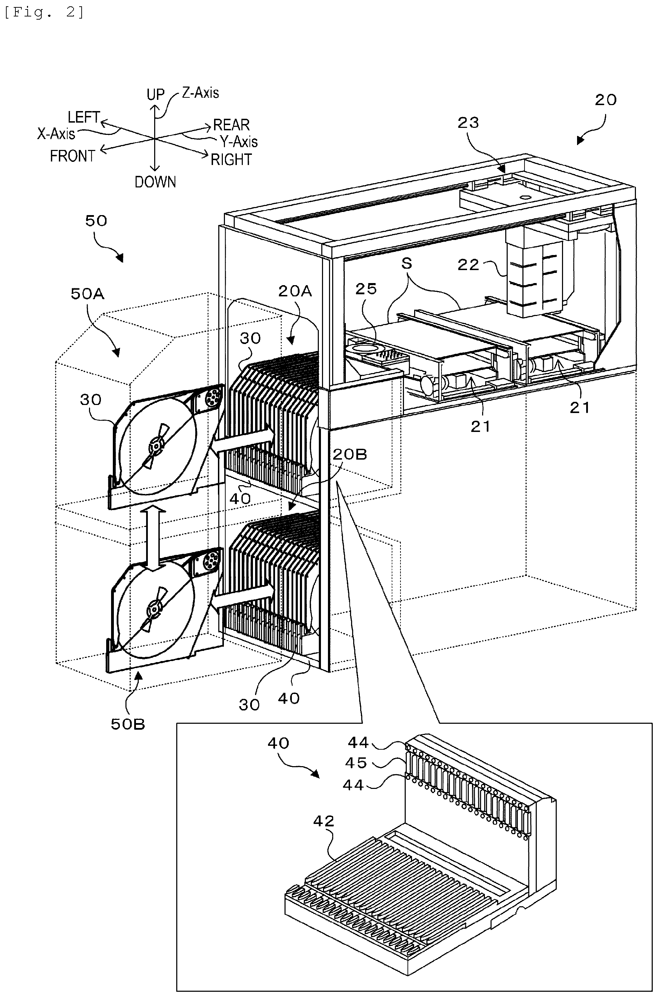

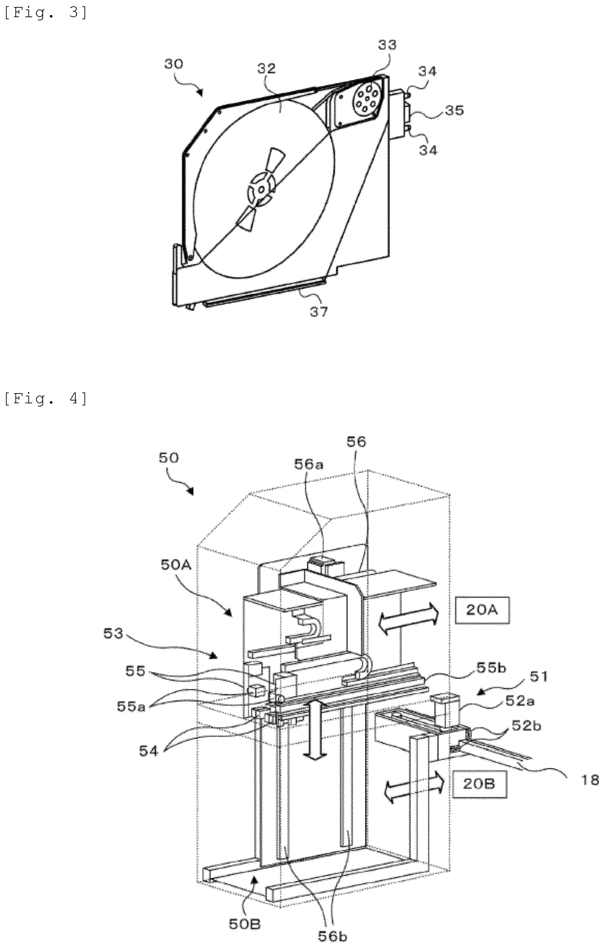

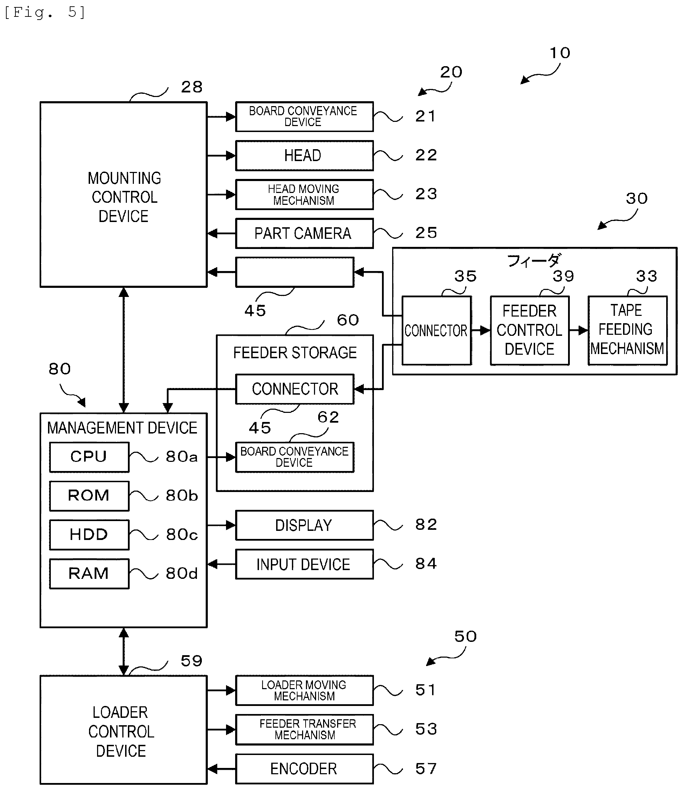

Fig. 1 is a configuration diagram illustrating a schematic configuration of component mounting system 10 of the present embodiment, Fig. 2 is a configuration diagram illustrating a schematic configuration of component mounter 20, and Fig. 3 is a configuration diagram illustrating a schematic configuration of feeder 30. In addition, Fig. 4 is a configuration diagram illustrating a schematic configuration of loader 50, and Fig. 5 is a configuration diagram relating to controlling of component mounting system 10. A right-left direction of Fig. 1 is an X-direction, a front-rear direction is a Y-direction, and an up-down direction is a Z-direction.

As illustrated in Fig. 1, component mounting system 10 includes printer 12, printing inspection machine 14, multiple component mounters 20, mounting inspection machine (not illustrated), loader 50, feeder storage 60, and management device 80 (refer to Fig. 5). Printer 12 prints a solder on board S. Printing inspection machine 14 inspects a state of the solder printed by printer 12. Multiple component mounter 20 are aligned and installed along a conveyance direction (X-direction) of board S, mount a component supplied from feeder 30 on board S. The mounting inspection machine inspects a mounting state of the component mounted on component mounter 20. Loader 50 supplies required feeder 30 to multiple component mounters 20, or collects used feeder 30 from component mounter 20. Feeder storage 60 stores feeder 30 scheduled to be used in component mounter 20 or used feeder 30. Management device 80 manages the whole system. Printer 12, printing inspection machine 14, multiple component mounter 20, and the mounting inspection machine are aligned and installed in the conveyance direction of board S in this order, thereby configuring a production line. Feeder storage 60 is incorporated into the production line of component mounting system 10, and is installed between component mounter 20 on a most upstream side in the conveyance direction of board S out of multiple component mounters 20 and printing inspection machine 14. In the present embodiment, a worker supplies feeder 30 to feeder storage 60, or collects feeder 30 from feeder storage 60. In addition to the above-described devices, component mounting system 10 may include a reflow device for performing a reflow process of board S having the component mounted thereon.

As illustrated in Fig. 2, component mounter 20 includes board conveyance device 21 for conveying board S in the X-direction, head 22 having a suction nozzle for picking up the component fed by feeder 30, head moving mechanism 23 for moving head 22 in an XY-direction, and part camera 25 for imaging the component picked up by the suction nozzle from below. In addition, component mounter 20 includes mounting control device 28 (refer to Fig. 5) configured to include a well-known CPU, ROM, or RAM for controlling the whole device. Mounting control device 28 inputs an image captured by part camera 25, or outputs a drive signal to board conveyance device 21, head 22, and head moving mechanism 23. In addition, a front side of component mounter 20 has two upper and lower areas where feeder 30 can be attached. The upper area is supply area 20A where feeder 30 can supply the component, and the lower area is stock area 20B where feeder 30 can be stocked. Supply area 20A and stock area 20B have feeder base 40 which is formed in an L-shape in a side view and to which multiple feeders 30 are respectively attached. Component mounter 20 may not include stock area 20B.

As illustrated in Fig. 3, feeder 30 is configured to serve as a tape feeder for feeding a tape for accommodating the component at a predetermined pitch. Feeder 30 includes tape reel 32 around which the tape is wound, tape feeding mechanism 33 for feeding the tape from tape reel 32, connector 35 having two positioning pins 34, rail member 37 provided in a lower end, and feeder control device 39 (refer to Fig. 5). As illustrated in Fig. 2, feeder base 40 includes multiple slots 42 arrayed in the X-direction at an interval through which rail member 37 of feeder 30 is enabled to be inserted, two positioning holes 44, and connector 45 provided between two positioning holes 44. Rail member 37 of feeder 30 is inserted into slot 42 of feeder base 40, and when two positioning pins 34 of feeder 30 are inserted into two positioning holes 44, connector 35 and connector 45 are connected to each other. Feeder control device 39 is configured to include a well-known CPU, ROM, or RAM, and outputs a drive signal to tape feeding mechanism 33. In addition, feeder control device 39 can communicate with a control section (mounting control device 28 or management device 80) of an attachment destination of feeder 30 via connection of connectors 35 and 45.

As illustrated in Fig. 1, loader 50 is movable along X-axis rail 18 provided parallel to the conveyance direction (X-direction) of the board on a front surface of multiple component mounters 20 and a front surface of feeder storage 60. In Fig. 2, X-axis rail 18 is omitted in the illustration. As illustrated in Figs. 4 and 5, loader 50 includes loader moving mechanism 51, feeder transfer mechanism 53, encoder 57, and loader control device 59. Loader moving mechanism 51 moves loader 50 along X-axis rail 18, and includes X-axis motor 52a such as a servo motor for driving a driving belt, and guide roller 52b for guiding a movement of loader 50 along X-axis rail 18. Feeder transfer mechanism 53 transfers feeder 30 to component mounter 20 or feeder storage 60. Feeder transfer mechanism 53 includes clamp section 54 for clamping feeder 30, and Y-axis slider 55 for moving clamp section 54 in the front-rear direction (Y-direction) along Y-axis guide rail 55b by driving Y-axis motor 55a. Feeder transfer mechanism 53 includes two Y-axis sliders 55, and multiple feeders 30 can be simultaneously transferred by multiple clamp sections 54. In addition, feeder transfer mechanism 53 includes slide base 56 to which clamp section 54 and Y-axis slider 55 are attached to be slidable, and Z-axis motor 56a for moving in the up-down direction (Z-direction) along Z-axis guide rail 56b. Encoder 57 detects a movement position of loader 50 in the X-direction. Loader control device 59 is configured to include a well-known CPU, ROM, or RAM. Loader control device 59 inputs a detection signal transmitted from encoder 57 or monitoring sensors 58a and 58b, and outputs a drive signal to loader moving mechanism 51 (X-axis motor 52a) or feeder transfer mechanism 53 (clamp section 54, Y-axis motor 55a, or Z-axis motor 56a).

When automatic exchange of feeder 30 is performed, loader control device 59 first moves loader 50 to reach a position facing Y-axis slider 55 of loader 50, in slot 42 of component mounter 20 which performs the automatic exchange by controlling X-axis motor 52a. In addition, when the automatic exchange is performed with supply area 20A of component mounter 20, loader control device 59 moves slide base 56 (Y-axis slider 55) to upper transfer area 50A facing supply area 20A by controlling Z-axis motor 56a. On the other hand, when the automatic exchange is performed with stock area 20B of component mounter 20, loader control device 59 moves slide base 56 to lower transfer area 50B facing stock area 20B by controlling Z-axis motor 56a. When feeder 30 inside loader 50 is attached to component mounter 20, in a state where feeder 30 is clamped by clamp section 54, loader control device 59 moves Y-axis slider 55 to component mounter 20 side (rearward) by controlling Y-axis motor 55a. In this manner, rail member 37 of feeder 30 is inserted into slot 42 of feeder base 40. Subsequently, loader control device 59 releases feeder 30 clamped by clamp section 54, thereby attaching feeder 30 to feeder base 40 of component mounter 20. In addition, when feeder 30 is detached from component mounter 20 and is collected into loader 50, loader control device 59 moves Y-axis slider 55 to component mounter 20 side (rearward) by controlling Y-axis motor 55a. Subsequently, after feeder 30 attached to feeder base 40 is clamped by clamp section 54, loader control device 59 moves Y-axis slider 55 forward by controlling Y-axis motor 55a. **In** this manner, feeder 30 is detached from feeder base 40, and is collected into loader 50.

In order to accommodate multiple feeders 30, feeder storage 60 has feeder base 40 having a configuration the same as that of feeder base 40 provided in component mounter 20. Loader 50 can attach and detach feeder 30 to and from feeder base 40 of feeder storage 60 by performing the same operation in attaching and detaching feeder 30 to and from feeder base 40 of component mounter 20. In addition, board conveyance device 62 for conveying board S in the X-direction is provided behind feeder storage 60. Board conveyance device 62 can convey board S received from a board conveyance device of printing inspection machine 14, and can transfer board S to board conveyance device 21 of adjacent component mounter 20.

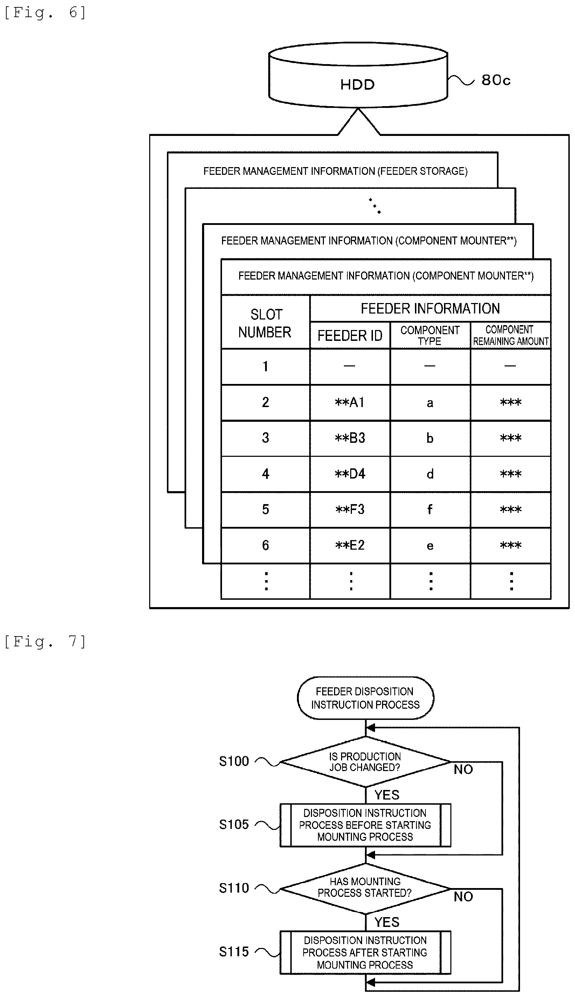

As illustrated in Fig. 5, management device 80 is configured to include well-known CPU 80a, ROM80b, HDD80c, or RAM80d, and includes display 82 such as an LCD or input device 84 such as a keyboard and a mouse. Management device 80 stores a production job of board S or feeder management information. As the production job, it is determined that each of component mounters 20 mounts any component type of the component on board S in any sequence, or it is determined to produce how many boards S for mounting the component in this way. In addition, as the production job, when multiple feeders 30 corresponding to the component type to be mounted by each of component mounters 20 are mounted on feeder base 40 of supply area 20A, an optimum disposition indicating the alignment of feeder 30 which is suitable for mounting process is determined. For example, scheduled mounting time Ts per one board using the component supplied from multiple feeders 30 is obtained by simulation (desktop calculation), and the optimum disposition of feeder 30 is determined as efficient disposition in which scheduled mounting time Ts is shortest. In the simulation, a collection position or a collection order when the suction nozzle of head 22 collects the component from feeder 30, a movement distance or a movement speed to a mounting position after the component is collected, and scheduled mounting time Ts corresponding to the number of mounting times for each component type can be obtained. The feeder management information relates to feeder 30 possessed by each component mounter 20 and feeder storage 60. Fig. 6 is view for describing an example of feeder management information. As illustrated, the feeder management information includes a slot number (position information) of feeder base 40 on which each feeder 30 is mounted, a feeder ID (identification information) of feeder 30 mounted on each slot 42, a component type possessed by each feeder 30, and a remaining amount of the components. Each mounting control device 28 similarly manages the feeder management information of the host device.

In addition, management device 80 is connected in a wired manner to be capable of communicating with mounting control device 28, is connected in a wireless manner to be capable of communicating with loader control device 59, and is also connected to be capable of communicating with each control device of printer 12, printing inspection machine 14, and the mounting inspection machine. Management device 80 receives information relating to a mounting state of component mounter 20, or information relating to attached and detached feeder 30, from mounting control device 28, or receives information relating to a driving state of loader 50 from loader control device 59. When management device 80 receives information relating to feeder 30 attached to feeder base 40 of component mounter 20 or feeder 30 detached from feeder base 40 from mounting control device 28, management device 80 updates the feeder management information of component mounter 20. In addition, management device 80 outputs a drive signal to board conveyance device 62 of feeder storage 60, and conveys board S to board conveyance device 62. In addition, management device 80 is connected via connectors 35 and 45 to be capable of communicating with feeder control device 39 of feeder 30 attached to feeder base 40 of feeder storage 60, and can acquire information of feeder 30. When management device 80 acquires the information relating to feeder 30 attached to feeder base 40 of feeder storage 60 or feeder 30 detached from feeder base 40, management device 80 updates the feeder management information of feeder storage 60.

An operation of component mounting system 10 configured in this way, particularly an operation when loader 50 is instructed to dispose feeder 30 will be described. Fig. 7 is a flowchart illustrating an example of a feeder disposition instruction process. The process is performed by CPU 80a of management device 80. In the feeder disposition instruction process, CPU 80a determines whether it is a changing timing of the production job (S100), and when CPU 80a determines that it is not the changing timing, the process proceeds to S110. When CPU 80a determines that it is the changing timing, CPU 80a performs a disposition instruction process before the mounting process starts for disposing feeder 30 required for the mounting process based on a new production jobs in component mounter 20 (S105), and the process proceeds to S110. At the changing timing of the production job, a preparation work such as exchange of feeder 30 or exchange of a nozzle based on the instruction in S105 is performed. When the preparation work is completed, CPU 80a instructs each component mounter 20 to start performing the mounting process based on the production job. Next, CPU 80a determines whether the mounting process based on the production job has started in component mounter 20 (S110), and when CPU 80a determines that the mounting process has not started, the process returns to S100. In addition, when CPU 80a determines that the mounting process has started, CPU 80a performs the disposition instruction process after the mounting process starts (S115), the process returns to S100. In the feeder disposition instruction process, a process of instructing automatic exchange of feeder 30 is performed in a case where there is no more remaining amount of the components of feeder 30 in use; however, description thereof will be omitted since this case does not constitute the gist of the present disclosure. Hereinafter, a process in S105 and a process in S115 will be subsequently described in detail.

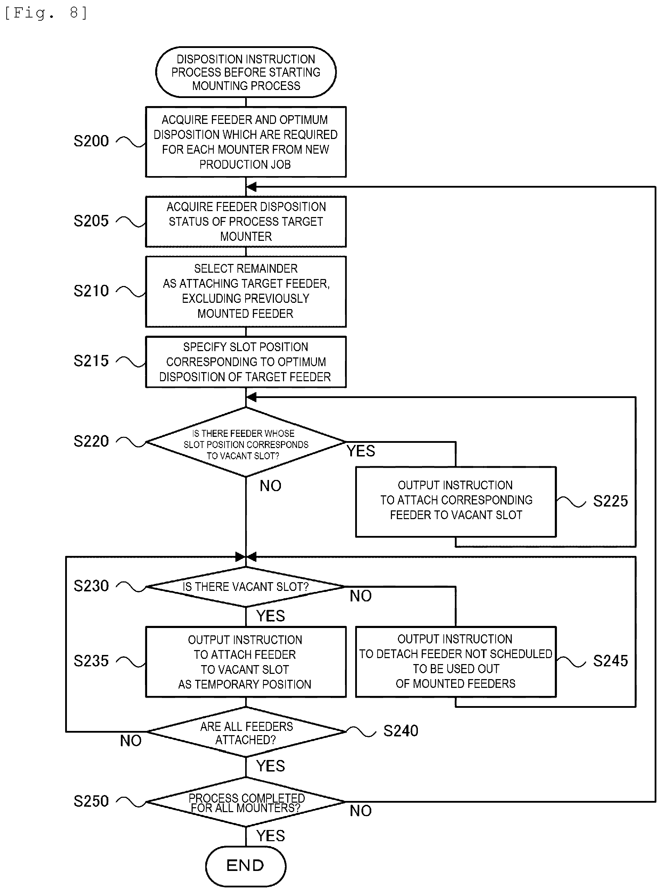

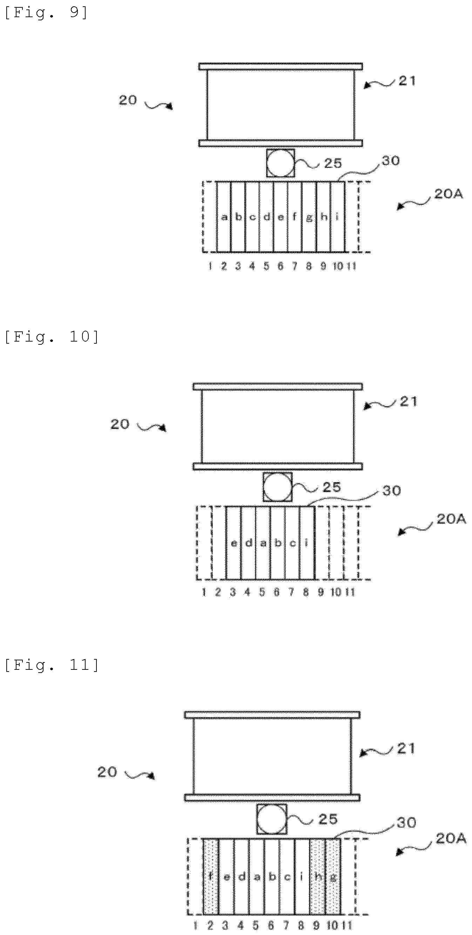

The disposition instruction process before the mounting process starts in S105 is performed, based on a flowchart in Fig. 8. In the process, CPU 80a acquires feeder 30 and optimum disposition which correspond to the component type required in each component mounter 20 from a new production job (S200). Fig. 9 is a view for describing an example of the optimum disposition of feeder 30, illustrates the optimum disposition in component mounter 20 in Fig. 1, and numerals in the drawing indicate slot positions (numbers). The optimum disposition is configured so that feeders 30 of component types a to i are aligned at slot positions 2 to 10 in this order, and feeders 30 are not mounted at slot positions 1 and 11. When the nozzle picks up the component from feeder 30, head 22 moves on board S via part camera 25. Therefore, the optimum disposition of feeder 30 is usually disposed around slot position 6 close to part camera 25.

Next, CPU 80a acquires a disposition status of feeder 30 in process target component mounter 20 from feeder management information (S205). Since the disposition instruction process before the mounting process starts is performed during the preparation work, feeder 30 used in the mounting process based on the previous production job is mounted on each slot 42 of supply area 20A of component mounter 20. Therefore, in S205, the feeder ID or the slot position of feeder 30 mounted in the previous production jobs is acquired. Subsequently, CPU 80a selects a remainder excluding previously mounted feeder 30 in supply area 20A of component mounter 20 out of feeders 30 required for the mounting process, as attaching target feeder 30 (S210), and specifies a slot position corresponding to the optimum disposition of attaching target feeder 30 (S215).

Fig. 10 is a view for describing a disposition status of feeder 30 when the mounting process based on the previous production job is completed. In Fig. 10, feeders 30 of component type e, d, a, b, c, and i are disposed at slot positions 3 to 8, and slot positions 1, 2, and 9 to 11 are vacant slots. When feeders 30 of component types a to i are required for the mounting process, feeder 30 of remaining component types f, g, and h excluding mounted feeders 30 of component types a to e and i are selected as the attaching target. In S215, CPU 80a specifies slot positions 7, 8, and 9 as the slot positions corresponding to the optimum disposition of feeders 30 of component types f, g, and h. Although the slot positions of feeders 30 of previously mounted component types a to e and i are all different from those in the optimum disposition illustrated in Fig. 9, switching to the optimum disposition is not performed before the mounting process starts in the present embodiment. Therefore, while mounted feeders 30 of component types a to e and i remain located at the temporary positions different from those in the optimum disposition, the mounting process starts.

Thereafter, CPU 80a determines whether there is a feeder 30 whose slot position specified by S215 corresponds to a vacant slot (S220). When CPU 80a determines that there is corresponding feeder 30, CPU 80a outputs an instruction to attach corresponding feeder 30 to the vacant slot to loader 50 (S225), and the process returns to S220. In Fig. 9, slot position 9 corresponds to the optimum disposition of feeder 30 of component type h, and in Fig. 10, slot position 9 is the vacant slot. Therefore, CPU 80a designates the vacant slot at slot position 9, and outputs an instruction to attach feeder 30 of component type h to the vacant slot in S225. The instruction in S225 includes whether slot 42 from which attaching target feeder 30 is detached is feeder storage 60, supply area 20A of component mounter 20, or stock area 20B. Based on the instruction in S225, loader 50 performs the automatic exchange by detaching attaching target feeder 30 from slot 42 and attaching feeder 30 to the vacant slot corresponding to the optimum disposition.

On the other hand, when CPU 80a determines that there is no feeder 30 whose slot position corresponds to the vacant slot in S220, CPU 80a determines whether there are other vacant slots (S230). In Fig. 10, CPU 80a determines that there are vacant slots, such as slot positions 1, 2, 10, and 11. When CPU 80a determines that there is the vacant slot, CPU 80a outputs an instruction to attach any of attaching target feeders 30 to the vacant slot as the temporary position, to loader 50 (S235), and the process proceeds to S240. CPU 80a designates a position having best work efficiency in the vacant slots, for example, the vacant slot close to the part camera 25, as the temporary position. Based on the instruction in S235, loader 50 performs the automatic exchange by detaching attaching target feeder 30 from designated slot 42 and attaching feeder 30 to the vacant slot as the temporary position. In this way, even when the slot position corresponding to the optimum disposition of attaching target feeder 30 is not the vacant slot, feeder 30 is attached at the temporary position, and accordingly, feeder 30 can be quickly attached.

Next, CPU 80a determines whether all attaching target feeders 30 are attached (S240), and when CPU 80a determines that all are not attached, the process returns to S230. In addition, when CPU 80a determines that there is no vacant slot in S230, CPU 80a outputs an instruction to loader 50 to detach feeder 30 which is not scheduled to be used in the mounting process based on the new production job out of mounted feeders 30 (S245), and the process returns to S230. The instruction in S245 also includes designation of an attachment destination of detached feeder 30. When feeder 30 is detached by loader 50 to have the vacant slot, CPU 80a determines that there is the vacant slot in S230, and performs a process in S235. Through the processes, feeder 30 required for the mounting process based on the new production job is attached to supply area 20A of component mounter 20. Fig. 11 is a view for describing a disposition status of feeder 30 by the disposition instruction before the mounting process start. As described above, feeder 30 of component type h is attached to slot position 9, and feeders 30 of component types f and g are attached to slot positions 2 and 10 as the temporary position. Thereafter, when CPU 80a determines that all attaching target feeders 30 are attached in S240, CPU 80a determines whether the disposition instruction is completed in all component mounters 20 (S250). When CPU 80a determines that the disposition instruction is not completed in all component mounters 20, CPU 80a returns to S205 to repeat the processes, and when CPU 80a determines that the disposition instruction is completed in all component mounters 20, CPU 80a completes the disposition instruction process before the mounting process starts.

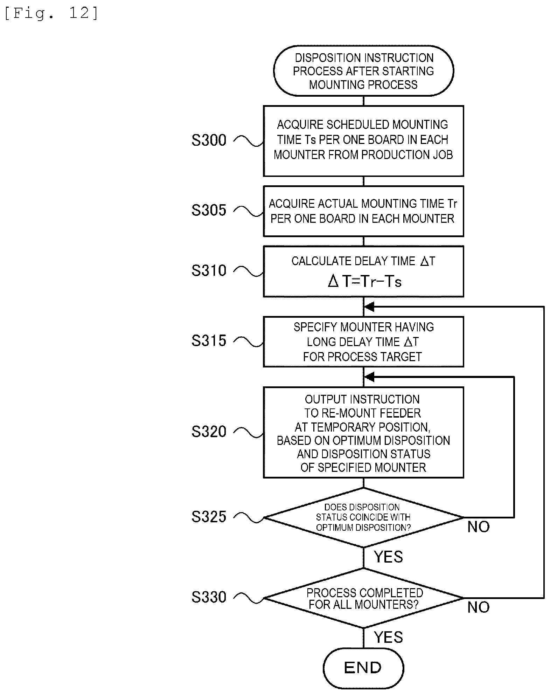

The disposition instruction process after starting the mounting process in S115 is performed, based on a flowchart in Fig. 12. In the process, CPU 80a acquires scheduled mounting time Ts per one board S in each component mounter 20 from the production job (S300). Next, CPU 80a acquires actual mounting times Tr actually required for the mounting process per one board S in each component mounter 20 (S305). For example, actual mounting time Tr is configured so that a time measured by mounting control device 28 of each component mounter 20 is acquired by CPU 80a through communication. Subsequently, CPU 80a calculates delay time ΔT by subtracting scheduled mounting time Ts from actual mounting time Tr (S310). Here, when feeder 30 is in the optimum disposition, actual mounting time Tr is acquired to have almost no difference from scheduled mounting time Ts. However, in component mounting system 10, since feeder 30 is disposed at the temporary position to start the mounting process, it may take a longer time to collect the component than scheduled, or it may take a longer time to mount the collected component than scheduled. In this case, actual mounting time Tr is longer than scheduled mounting time Ts, and thus, delay time ΔT occurs. Delay time ΔT varies depending on a separated degree between the slot position corresponding to the optimum disposition and the temporary position, the number of feeders 30 mounted at the temporary position, or the number of components collected from feeders 30 mounted at the temporary position.

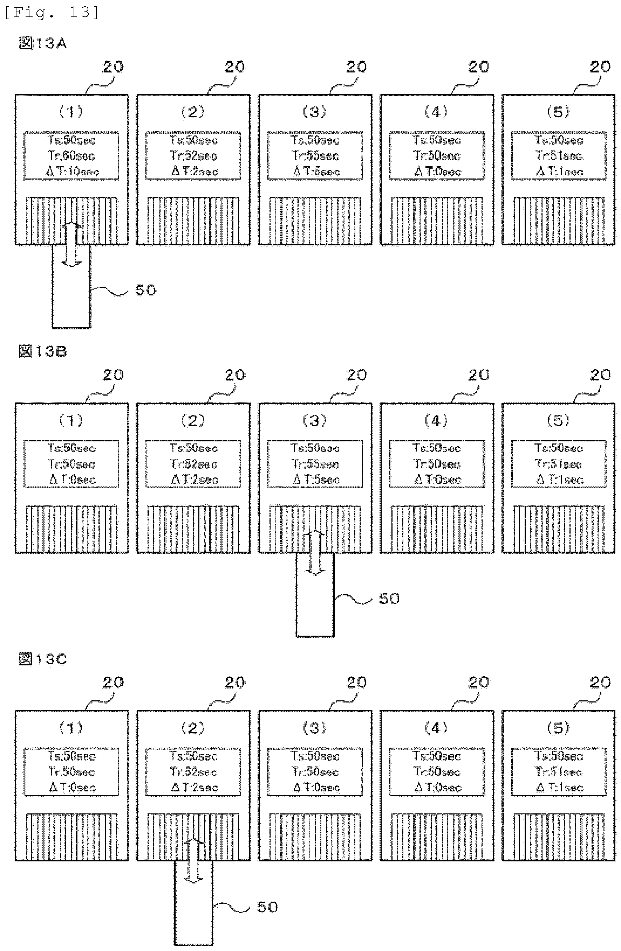

Thereafter, CPU 80a specifies component mounter 20 having long delay time ΔT out of respective component mounters 20, as a process target (S315). In S315, component mounter 20 having longest delay time ΔT, that is, component mounter 20 which is a bottleneck is specified as the process target. Here, Fig. 13 is a view for describing delay time ΔT and a disposition change in feeder 30. Fig. 13 illustrates scheduled mounting time Ts, actual mounting time Tr, and delay time ΔT in five component mounters 20(1) to 20(5) as an example. Although scheduled mounting time Ts varies depending on the component type, the number of components mounted by component mounter 20, and the mounting position on board S, the same time is applied herein. As illustrated in Fig. 13A, since delay time ΔT increases in the order of component mounters 20(4), 20(5), 20(2), 20(3), and 20(1), CPU 80a specifies component mounter 20(1) as the process target in S315. In component mounter 20(4), feeder 30 is in the optimum disposition before the mounting process starts, and delay time ΔT is zero seconds. Since each component mounter 20 performs the mounting process while subsequently conveying boards S from an upstream side, depending on a timing for performing the disposition instruction process after the mounting process starts, the mounting process may not yet be performed on board S, and there may be component mounter 20 for which actual mounting time Tr is not acquired. In this case, as the process target, CPU 80a may specify component mounter 20 having longer delay time ΔT out of component mounters 20 for which actual mounting time Tr is acquired.

Next, CPU 80a outputs an instruction to re-mount feeder 30 located at the temporary position at the slot position corresponding to the optimum disposition, to loader 50, based on the optimum disposition and the disposition status of process target component mounter 20 (S320). When receiving the instruction in S320, loader 50 performs the automatic exchange by unloading feeder 30 from the temporary position and attaching feeder 30 to the slot position corresponding to the optimum disposition. CPU 80a acquires a mounting state from mounting control device 28, and outputs the instruction in S330, by determining a timing at which the component is not supplied from re-mounted feeder 30, such as a timing at which board S is conveyed into or conveyed out from feeder 30. In this case, feeder 30 can be re-mounted without hindering the mounting process.

Thereafter, CPU 80a determines whether the disposition status of feeder 30 coincides with the optimum disposition (S325), when CPU 80a determines that the disposition status does not coincide with the optimum disposition, the process in S320 is repeated. In this manner, feeder 30 disposed as illustrated in Fig. 11 before the mounting process starts is changed to the optimum disposition as illustrated in Fig. 9 during the mounting process. When CPU 80a determines that the disposition status coincides with the optimum disposition, CPU 80a determines whether the process is completely performed in all component mounters 20 (S330). When CPU 80a determines that the process is not completely performed in all component mounters 20, the process returns to S315 to perform the process. Therefore, feeders 30 are subsequently re-mounted from component mounter 20 having long delay time ΔT. For example, in Fig. 13, when feeder 30 of component mounter 20(1) is re-mounted, feeder 30 of component mounter 20(3) is next re-mounted (Fig. 13B), feeder 30 of component mounter 20(2) is subsequently re-mounted (Fig. 13C), and feeder 30 of component mounter 20(5) is further re-mounted. Thereafter, when CPU 80a determines that the process is completely performed in all component mounters 20 in S330, CPU 80a completes the disposition instruction process after the mounting process starts.

Here, a correspondence relationship between the configuration elements of the present embodiment and configuration elements of the present invention will be clarified. Feeder 30 of the present embodiment corresponds to a component supply unit, component mounter 20 corresponds to a component mounter, loader 50 corresponds to a unit exchange device, and management device 80 and a loader control device 59 for performing a feeder exchange instruction process in Fig. 7 (disposition instruction process before the mounting process starts in Fig. 8, and the disposition instruction process after the mounting process start s in Fig. 12) corresponds to an exchange control device. In the present embodiment, an example of a disposition instruction method of the component supply unit of the present disclosure is also clarified by describing the process of management device 80.

In component mounting system 10 described above, feeder 30 is mounted on component mounter 20 by allowing the temporary position different from that of the optimum disposition (predetermined disposition) before the mounting process starts based on the new production job. In addition, after the mounting process starts, feeder 30 mounted at the temporary position is re-mounted, based on the optimum disposition. In this manner, compared to a case where the mounting process starts after feeder 30 is in the optimum disposition when the production jobs are changed, the mounting process can more quickly start. In addition, feeder 30 is re-mounted in the optimum disposition after the mounting process starts, it is possible to suppress a significant decrease in efficiency of the mounting process.

In addition, since feeder 30 is preferentially mounted at the vacant position having not feeder 30 mounted thereon, as the temporary position, it is possible to further shorten a time required for mounting feeder 30.

In addition, since component mounter 20 having long delay time ΔT is specified after the mounting process starts and feeder 30 is re-mounted from component mounter 20, it is possible to suppress influence on the decrease in the efficiency of the mounting process when the mounting process starts in a disposition state different from the optimum disposition. In addition, the delay location of the mounting process can be properly specified, based on delay time ΔT calculated from scheduled mounting time Ts and actual mounting time Tr per one board. In addition, since component mounter 20 is re-mounted in units, feeder 30 can be quickly re-mounted in the optimum disposition by suppressing a movement loss of loader 50 frequently moving between component mounters 20.

For example, in the above-described embodiment, in the disposition instruction process before the mounting process starts, feeder 30 whose slot position corresponding to the optimum disposition is the vacant slot is mounted on the vacant slot; however, the configuration is not limited to this. For example, in the disposition instruction process before the mounting process starts, the feeder 30 may be attached to any vacant slot, regardless of whether the slot position corresponds to the optimum disposition. In addition, feeder 30 whose slot position corresponding to the optimum disposition is not the vacant slot is attached to any the other vacant slot; however, the configuration is not limited to this. For example, a vacant slot on which feeder 30 can be easily re-mounted at the slot position corresponding to the optimum disposition may be selected from other vacant slots, and feeder 30 may be attached to the selected vacant slot. For example, a vacant slot having a smallest movement amount of loader 50 when feeder 30 is re-mounted at the slot position corresponding to the optimum disposition may be selected.

In the above-described embodiment described, in the disposition instruction process after the mounting process starts, the process targets are subsequently specified from component mounters 20 having longest delay time ΔT, and feeder 30 is re-mounted; however, the configuration is not limited to this. For example, when there are multiple component mounters 20 having no great difference in delay time ΔT, the process target may be specified from component mounters 20 close to a current position of loader 50 to further suppress the movement loss of loader 50 frequently moving between component mounters 20. That is, process target component mounter 20 may be specified, based on delay time T and the movement distance of loader 50.

In the above-described embodiment, in the disposition instruction process after the mounting process start, the location for re-mounting feeder 30 is specified in units of component mounter 20; however, without being limited to this, the location may be specified in units of feeder 30. For example, for all feeders 30 disposed at the temporary position, the delay time is derived, based on a difference between the time required from the collection to the mounting of the component in a case of the optimum disposition and the time required from the collection to the mounting of the component in a case of the temporary position. Thereafter, feeders 30 having the long delay time may be re-mounted as the delay location in the longest order, or multiple feeders 30 including feeder 30 having the long delay time and feeder 30 at the surrounding temporary position may be re-mounted as the delay locations.

In the above-described embodiment, in the disposition instruction process after the mounting process starts, feeder 30 is re-mounted from the location (component mounter 20) having long delay time ΔT; however, the configuration is not limited to this. For example, without calculating delay time ΔT, feeders 30 may be subsequently re-mounted from the locations where feeder 30 is not in the optimum disposition. In this case, feeders 30 may be subsequently re-mounted from the upstream side or downstream side out of component mounters 20 which are not in the optimum disposition so that a movement direction of loader 50 is one direction. Alternatively, without calculating delay time ΔT, feeder 30 may be re-mounted from component mounter 20 having longest actual mounting time Tr per one board S. In this case, scheduled mounting time Ts may be used instead of actual mounting time Tr with regard to component mounter 20 on which the mounting process is not yet performed on board S and for which actual mounting time Tr is not acquired.

In the above-described embodiment, loader 50 that performs the automatic exchange of feeder 30 has been described so that the instruction of disposing feeder 30 is output to loader 50; however, without being limited to this, an instruction to dispose feeder 30 may be output to a worker. In this case, for example, the instruction may be output to the worker by displaying the instruction to dispose feeder 30 on a screen of a portable terminal possessed by the worker.

In the component mounting system of the present disclosure, the exchange control device may control the unit exchange device so that the remaining component supply unit excluding the component supply unit mounted during the previously performed production job, out of the component supply units required for the mounting process, is preferentially mounted at the vacant position where the component supply unit is not mounted, as the temporary position, before the mounting process starts. In this case, since the component supply unit required for the mounting process can be quickly mounted, a time required for the mounting can be further shortened, and the mounting process can more quickly start.

In the component mounting system of the present disclosure, the exchange control device may specify the delay location where the longer delay occurs in the mounting process, out of the locations including the temporary position where the component supply unit is mounted, after the mounting process starts, and may control the unit exchange device to re-mount the component supply unit from the delay location. In this case, it is possible to suppress influence on the decrease in the efficiency of the mounting process when the mounting process starts in a state different from that of the predetermined disposition.

In the component mounting system of the present disclosure, the exchange control device may specify the delay location, based on a difference between the scheduled time scheduled for the mounting process per one board when the component supply unit is in a state of the predetermined disposition and the actual time required for the mounting process per one board when the component supply unit is in a state different from that of the predetermined disposition. In this case, since the delay location of the mounting process can be properly specified, it is possible to properly suppress the influence on decrease in the efficiency of the mounting process.

In the component mounting system of the present disclosure, the unit exchange device may move along the alignment direction of the multiple component mounters to perform the automatic exchange, and the exchange control device may specify the delay location in units of the component mounter. In this case, the component supply unit can be quickly re-mounted in the predetermined disposition by suppressing the movement loss of the component supply unit frequently moving between the component mounters when the unit exchange device re-mounts component supply unit.

According to the present disclosure, there is provided the method for instructing disposition of the component supply unit in the component mounter on which multiple component supply units are aligned and detachably mounted, and which is configured to perform the mounting process of mounting the component on the board by collecting the component from the component supply units, based on the production job. The disposition instruction method includes (a) a step of outputting an instruction so that the component supply unit required for the mounting process is mounted on the component mounter by allowing a temporary position different from a predetermined alignment disposition suitable for the mounting process, before the mounting process starts based on a new production job; and
(b) a step of outputting an instruction so that the component supply unit mounted at the temporary position is re-mounted on the component mounter, based on the predetermined disposition, after the mounting process starts.

**In** the method for instructing disposition of the component supply unit of the present disclosure, before the mounting process starts based on the new production job, the required component supply unit is instructed to be mounted on the component mounter by allowing the temporary position different from the predetermined alignment disposition suitable for the mounting process. In addition, after the mounting process starts, the component supply unit mounted at the temporary position is instructed to be re-mounted, based on the predetermined disposition. Therefore, since the component supply units are disposed as instructed, it is possible to suppress the decrease in the efficiency of the mounting process while the mounting process quickly starts when the production jobs are changed, as in the above-described component mounting system. In the method for instructing disposition of the component supply unit, various aspects of the above-described component mounting system may be adopted, or a step for realizing each function of the above-described component mounting system may be added.

### Industrial Applicability

The present invention is applicable to a manufacturing industry of the component mounting system.

### Reference Signs List

10 component mounting system, 12 printer, 14 printing inspection machine, 18 X-axis rail, 20 component mounter, 20A supply area, 20B stock area, 21 board conveyance device, 22 head, 23 head moving mechanism, 25 part camera, 28 mounting control device, 30 feeder, 32 tape reel, 33 tape feeding mechanism, 34 positioning pin, 35 connector, 37 rail member, 39 feeder control device, 40 feeder base, 42 slot, 44 positioning hole, 45 connector, 50 loader, 50A upper transfer area, 50B lower transfer area, 51 loader moving mechanism, 52a X-axis motor,52b guide roller, 53 feeder transfer mechanism, 54 clamp section, 55 Y-axis slider, 55a Y-axis motor, 55b Y-axis guide rail, 56 slide base, 56a Z-axis motor, 56b Z-axis guide rail, 57 encoder, 59 loader control device, 60 feeder storage, 62 board conveyance device, 80 management device, 80a CPU, 80b ROM, 80c HDD, 80d RAM, 82 display, 84 input device, S board

## Claims

1. A component mounting system (10) including a component mounter (20) on which multiple component supply units (30) are aligned and detachably mounted, and which is configured to perform a mounting process of mounting a component on a board (S) by collecting the component from the component supply units, based on a production job, the system comprising:
a unit exchange device (50) configured to automatically exchange the component supply units within the component mounter; and
an exchange control device (80, 59);
**characterized by**
the exchange control device configured to control the unit exchange device so that:
- the component supply unit required for the mounting process is mounted on the component mounter by allowing a temporary position within a supply area (20A) of the component mounter different from a predetermined alignment disposition within the supply area suitable for the mounting process, before the mounting process starts based on a new production job;
- the remaining component supply unit excluding the component supply unit mounted during the previously performed production job, out of the component supply units required for the mounting process, is preferentially mounted at a vacant position where the component supply unit is not mounted, as the temporary position, before the mounting process starts; and
- the component supply unit mounted at the temporary position is re-mounted within the supply area, based on the predetermined disposition, after the mounting process starts.

2. The component mounting system according to Claim 1,
wherein the exchange control device is configured to specify a delay location where a longer delay occurs in the mounting process, out of locations including the temporary position where the component supply unit is mounted, after the mounting process starts, and controls the unit exchange device to re-mount the component supply unit from the delay location.

3. The component mounting system according to Claim 2,
wherein the exchange control device is configured to specify the delay location, based on a difference between a scheduled time scheduled for the mounting process per one board when the component supply unit is in a state of the predetermined disposition and an actual time required for the mounting process per one board when the component supply unit is in a state different from that of the predetermined disposition.

4. The component mounting system according to Claim 2 or 3,
wherein the unit exchange device is configured to move along an alignment direction of the multiple component mounters so as to perform automatic exchange, and
wherein the exchange control device is configured to specify the delay location in units of the component mounter.

5. A method for instructing disposition of a component supply unit (30) in a component mounter (20) on which multiple component supply units (30) are aligned and detachably mounted, and which is configured to perform a mounting process of mounting a component on a board (S) by collecting the component from the component supply units, based on a production job, the method comprising:
a) a step of outputting (S105) an instruction so that the component supply unit required for the mounting process is mounted on the component mounter by allowing a temporary position within a supply area (20A) of the component mounter different from a predetermined alignment disposition within the supply area suitable for the mounting process, before the mounting process starts based on a new production job;
b) a step of outputting (S235) an instruction so that the remaining component supply unit excluding the component supply unit mounted during the previously performed production job, out of the component supply units required for the mounting process, is preferentially mounted at a vacant position where the component supply unit is not mounted, as the temporary position, before the mounting process starts; and
c) a step of outputting (S115) an instruction so that the component supply unit mounted at the temporary position is re-mounted within the supply area, based on the predetermined disposition, after the mounting process starts.

## Patentansprüche

1. Bauteilmontagesystem (10), das eine Bauteilmontagevorrichtung (20) aufweist, auf der mehrere Bauteilzuführeinheiten (30) ausgerichtet und abnehmbar montiert sind, und die so konfiguriert ist, dass sie einen Montageprozess zum Montieren eines Bauteils auf einer Platte (S) durch Sammeln des Bauteils von den Bauteilzuführeinheiten auf der Basis eines Produktionsauftrags durchführt, wobei das System Folgendes aufweist:
eine Einheitenaustauschvorrichtung (50), die so konfiguriert ist, dass sie die Bauteilzufuhreinheiten innerhalb der Bauteilmontagevorrichtung automatisch austauscht; und
eine Austauschsteuerungsvorrichtung (80, 59);
**gekennzeichnet durch**
die Austauschsteuerungsvorrichtung konfiguriert ist, um die Einheitsaustauschvorrichtung so zu steuern, dass:
- die Bauteilzuführeinheit, die für den Montageprozess benötigt wird, an der Bauteilmontagevorrichtung montiert wird, indem eine temporäre Position innerhalb eines Versorgungsbereichs (20A) der Bauteilmontagevorrichtung ermöglicht wird, die sich von einer vorbestimmten Ausrichtungsanordnung innerhalb des Versorgungsbereichs, die für den Montageprozess geeignet ist, unterscheidet, bevor der Montageprozess basierend auf einem neuen Produktionsauftrag beginnt;
- die verbleibende Bauteilzuführeinheit mit Ausnahme der Bauteilzuführeinheit, die während des zuvor durchgeführten Produktionsauftrags montiert wurde, von den Bauteilzuführeinheiten, die für den Montagevorgang benötigt werden, vorzugsweise an einer freien Position montiert wird, an der die Bauteilzuführeinheit nicht montiert ist, als die temporäre Position, bevor der Montagevorgang beginnt; und
- die an der temporären Position montierte Bauteilzuführeinheit nach Beginn des Montagevorgangs auf der Grundlage der vorbestimmten Anordnung innerhalb des Versorgungsbereiches ummontiert wird.

2. Bauteilmontagesystem nach Anspruch 1,
wobei die Austauschsteuerungsvorrichtung so konfiguriert ist, dass sie eine Verzögerungsstelle spezifiziert, an der eine längere Verzögerung im Montageprozess auftritt, und zwar außerhalb der Stellen, die die temporäre Position einschließen, an der die Bauteilzuführeinheit montiert ist, nachdem der Montageprozess beginnt, und die Einheitsaustauschvorrichtung steuert, um die Bauteilzuführeinheit von der Verzögertstelle aus wieder zu montieren.

3. Bauteilmontagesystem nach Anspruch 2,
wobei die Austauschsteuerungsvorrichtung so konfiguriert ist, dass sie die Verzögertstelle auf der Grundlage einer Differenz zwischen einer geplanten Zeit, die für den Montagevorgang pro Platte vorgesehen ist, wenn sich die Bauteilzuführeinheit in einem Zustand der vorbestimmten Disposition befindet, und einer tatsächlichen Zeit, die für den Montagevorgang pro Platte erforderlich ist, wenn sich die Bauteilzuführeinheit in einem Zustand befindet, der sich von dem der vorbestimmten Disposition unterscheidet, bestimmt.

4. Bauteilmontagesystem nach Anspruch 2 oder 3,
wobei die Einheitsaustauschvorrichtung so konfiguriert ist, dass sie sich entlang einer Ausrichtungsrichtung der mehreren Bauteilmontagevorrichtungen bewegt, um einen automatischen Austausch durchzuführen, und
wobei die Austauschsteuerungsvorrichtung so konfiguriert ist, dass sie die Verzögertstelle in Einheiten der Bauteilmontagevorrichtung angibt.

5. Verfahren zum Anweisen der Anordnung einer Bauteilzuführeinheit (30) in einer Bauteilmontagevorrichtung (20), auf der mehrere Bauteilzuführeinheiten (30) ausgerichtet und abnehmbar montiert sind, und die so konfiguriert ist, dass sie einen Montageprozess zum Montieren eines Bauteils auf einer Platte (S) durch Sammeln des Bauteils von den Bauteilzuführeinheiten auf der Basis eines Produktionsauftrags durchführt, wobei das Verfahren aufweist:
a) einen Schritt des Ausgebens (S105) einer Anweisung, so dass die Bauteilzuführeinheit, die für den Bestückungsprozess benötigt wird, an der Bauteilmontagevorrichtung montiert wird, indem eine temporäre Position innerhalb eines Versorgungsbereichs (20A) der Bauteilmontagevorrichtung zugelassen wird, die sich von einer vorbestimmten Ausrichtungsanordnung innerhalb des Versorgungsbereichs, die für den Bestückungsprozess geeignet ist, unterscheidet, bevor der Bestückungsprozess basierend auf einem neuen Produktionsauftrag beginnt;
b) einen Schritt des Ausgebens (S235) einer Anweisung, so dass die verbleibende Bauteilzuführeinheit mit Ausnahme der Bauteilzuführeinheit, die während des zuvor durchgeführten Produktionsauftrags montiert wurde, von den Bauteilzuführeinheiten, die für den Montageprozess benötigt werden, vorzugsweise an einer freien Position montiert wird, wo die Bauteilzuführeinheit nicht montiert ist, als die temporäre Position, bevor der Montageprozess beginnt; und
c) einen Schritt des Ausgebens (S115) einer Anweisung, so dass die Bauteilzuführeinheit, die an der temporären Position montiert ist, innerhalb des Versorgungsbereichs wieder montiert wird, basierend auf der vorbestimmten Disposition, nachdem der Montageprozess beginnt.

## Revendications

1. Système de montage de composants (10) comprenant un dispositif de montage de composants (20) sur lequel de multiples unités d'alimentation en composants (30) sont alignées et montées de manière amovible, et qui est configuré pour effectuer un processus de montage permettant de monter un composant sur une carte (S) en collectant le composant à partir des unités d'alimentation en composants, sur la base d'un travail de production, le système comprenant :
un dispositif d'échange d'unités (50) configuré pour échanger automatiquement les unités d'alimentation en composants à l'intérieur du dispositif de montage de composants ; et
un dispositif de commande d'échange (80, 59) ;
**caractérisé en ce que**
le dispositif de commande d'échange est configuré pour commander le dispositif d'échange d'unités de manière à ce que :
- l'unité d'alimentation en composants requise pour le processus de montage soit montée sur le dispositif de montage de composants en autorisant une position temporaire dans une zone d'alimentation (20A) du dispositif de montage de composants différente d'une disposition d'alignement prédéterminée dans la zone d'alimentation adaptée au processus de montage, avant le début du processus de montage sur la base d'un nouveau travail de production ;
- l'unité d'alimentation en composants restante, à l'exception de l'unité d'alimentation en composants montée pendant le travail de production effectué précédemment, parmi les unités d'alimentation en composants requises pour le processus de montage, soit de préférence montée à une position vacante où l'unité d'alimentation en composants n'est pas montée, comme étant la position temporaire, avant le début du processus de montage ; et
- l'unité d'alimentation en composants montée à la position temporaire soit remontée dans la zone d'alimentation, sur la base de la disposition prédéterminée, après le début du processus de montage.

2. Système de montage de composants selon la revendication 1,
dans lequel le dispositif de commande d'échange est configuré pour spécifier un emplacement de retard où un retard plus important se produit dans le processus de montage, parmi les emplacements incluant la position temporaire où l'unité d'alimentation en composants est montée, après le début du processus de montage, et commande le dispositif d'échange d'unités pour remonter l'unité d'alimentation en composants à partir de l'emplacement de retard.

3. Système de montage de composants selon la revendication 2,
dans lequel le dispositif de commande d'échange est configuré pour spécifier l'emplacement de retard, sur la base d'une différence entre un temps programmé qui est programmé pour le processus de montage par carte lorsque l'unité d'alimentation en composants est dans un état de la disposition prédéterminée et un temps réel requis pour le processus de montage par carte lorsque l'unité d'alimentation en composants est dans un état différent de celui de la disposition prédéterminée.

4. Système de montage de composants selon la revendication 2 ou 3,
dans lequel le dispositif d'échange d'unités est configuré pour se déplacer le long d'une direction d'alignement des multiples dispositifs de montage de composants afin d'effectuer un échange automatique, et
dans lequel le dispositif de commande d'échange est configuré pour spécifier l'emplacement de retard en unités du dispositif de montage de composants.

5. Procédé pour instruire la disposition d'une unité d'alimentation en composants (30) dans un dispositif de montage de composants (20) sur lequel de multiples unités d'alimentation en composants (30) sont alignées et montées de manière amovible, et qui est configuré pour effectuer un processus de montage permettant de monter un composant sur une carte (S) en collectant le composant à partir des unités d'alimentation en composants, sur la base d'un travail de production, le procédé comprenant :
a) une étape de sortie (S105) d'une instruction pour que l'unité d'alimentation en composants requise pour le processus de montage soit montée sur le dispositif de montage de composants en autorisant une position temporaire dans une zone d'alimentation (20A) du dispositif de montage de composants différente d'une disposition d'alignement prédéterminée dans la zone d'alimentation adaptée au processus de montage, avant le début du processus de montage sur la base d'un nouveau travail de production ;
b) une étape de sortie (S235) d'une instruction pour que l'unité d'alimentation en composants restante, à l'exclusion de l'unité d'alimentation en composants montée pendant le travail de production effectué précédemment, parmi les unités d'alimentation en composants requises pour le processus de montage, soit de préférence montée à une position vacante où l'unité d'alimentation en composants n'est pas montée, comme étant la position temporaire, avant le début du processus de montage ; et
c) une étape de sortie (S115) d'une instruction pour que l'unité d'alimentation en composants montée à la position temporaire soit remontée dans la zone d'alimentation, sur la base de la disposition prédéterminée, après le début du processus de montage.
